# EUROPEAN PATENT APPLICATION

(11) **EP 1 285 977 A2**
(43) Date of publication of application: **26.02.2003**
(21) Application number: 02255775.5
(22) Date of filing: 20.08.2002
(51) Int. Cl.: C23C 16/44, F16J 15/00, H01L 21/00

(54) **Apparatus and method for insulating a seal in a process chamber**

(30) Priority: 20.08.2001 US 313719 P
(71) Applicant: ASML US, Inc., Scott Valley, California 95066 (US)
(72) Inventor: Robinson, David, Santa Cruz, CA 95060 (US); Draper, Michael, San Jose, CA 95120 (US)
(74) Representative: Stoner, Gerard Patrick

(57) **Abstract**

An apparatus and method are provided for insulating a seal (110) made of a polymeric material in a pressurized, evacuated or exhausted process chamber (100) that reduces damage due to heat transferred to the seal from the chamber. The chamber (100) includes a wall (125) having an aperture (140) therein, a flange (115) disposed about the aperture, and an insulator (105) between the flange and a fixture (120) to insulate the seal between the flange and the fixture. Generally, the insulator (105) includes a cooling tube or loop (260) having a sidewall (262) overlying and attached to the flange (115), and a cap (255) overlying the loop. The cap (255) has a sealing surface (257) against which the seal (110) seats. Fluid may be passed through the loop (260) to reduce heat transferred to the seal (110). Preferably, the flange (115), the loop (260), and the cap (255), are made of quartz or a glass, and the sidewall (262) of the loop is welded to the flange and the cap. More preferably, the loop (260) functions as a light pipe to direct heat radiating from the chamber (100) away from the seal (110).

## Description

The present application claims priority from commonly assigned, co-pending U.S. Provisional Patent Application Serial Number 60/313,719, entitled *Apparatus and method for insulating a seal in a process chamber,* and filed August 20, 2001, which is incorporated herein by reference.

The present invention relates generally to systems and methods for heat-treating objects, such as semiconductor substrates. More specifically, the present invention relates to an apparatus and method for insulating and maintaining a seal in a pressurized, evacuated or exhausted process chamber.

Heated process chambers are commonly used in manufacturing, for example, integrated circuits (ICs) or semiconductor devices for heat treating, annealing, and depositing or removing layers of material on a substrate.

Frequently, the process chambers are pressurized, evacuated or exhausted during a processing operation to provide a suitable processing environment and/or for the safety of personnel. In particular many of the reactants and process gases used in manufacturing semiconductors are highly toxic and/or flammable. Thus, all openings or apertures into the process chamber including those through which the substrates are loaded, process and vent gas supply lines, and vacuum or exhaust ports must be sealed with a gas tight seal to their respective fixtures and fittings Generally, these seals include gaskets or o-ring type seals made of a resilient polymeric material such as silicone, fluorosilicone, tetrafluoroethylene/Propylene or TFE/Propylene, fluorocarbon, polyacrylate, nitrile, hydrogenated nitrile, neoprene, ethylene propylene or butyl rubber.

One problem with conventional heated process chambers is thermal degradation of the seals and the resultant reduction in quality of the seal leading to the processing environment being compromised, including possible contamination from the degraded seal, and the potential exposure of personnel to hazardous materials. Heat conducted and radiated from the process chamber during a processing operation can cause the seals to lose their resilience, leading a gradual deterioration of the seal or a catastrophic failure. In an evacuated or exhausted process chamber, such as a low pressure chemical vapor deposition (LPCVD) system, deterioration of the seal can lead to outside air being drawn in and adversely effecting process chemistry and/or the thermal stability in the process chamber In some instances the deterioration of the seal can lead to contaminates being drawn into the process chamber, including contamination by particulate matter and/or out-gassing from the degraded seal itself.

Deterioration of the seal can in turn lead to increased operating costs and reduced equipment or process chamber availability. Because of the size, quality or purity, and chemical and temperature resistance required of seals used in process chambers, they frequently cost in excess of $2,500. Moreover, the equipment may be unavailable for days due to the need to cool down, heat up, season and re-qualify a process chamber following seal replacement. Thus, there is a need for an apparatus and method for insulating and maintaining seals used in process chambers.

Several approaches have been attempted to provide cooling for seals used in process chambers. One approach is described in U.S. Patent No. 5,5781329, to Yamaga et; al. (YAMAGA), hereby incorporated by reference. Referring to FIG. 1, YAMAGA discloses a glass process chamber 10, heated a number of heating elements12, and in which semiconductor substrates 14 are processed. Process and/or purge gas is introduced through a gas inlet 16, the process chamber 10 exhausted or evacuated through an exhaust port 18. The gas inlet 16 is sealed to a gas supply line (not shown) by an o-ring 17, and the exhaust port 18 is scaled by a gasket 19 to an exhaust trunk or vacuum pump foreline (not shown). The substrates 14 are held on a holder or support 20 mounted on a metal base plate 22 that can be raised or lowered by a lift mechanism (not shown) to load and remove the substrates. In the raised position the base plate 22 is sealed to a flange 24 of the process chamber 10 by an o-ring 26. Water is passed through a coolant channel 28 in the base plate 22 below and adjacent to the o-ring 26 to cool the o-ring.

While an improvement over earlier un-cooled designs, the approach shown in YAMAGA is not wholly satisfactory for a number of reasons. One problem is that only one side of the o-ring 26 is cooled, and that the side away from the heated process chamber 10 Heat is still conducted to the o-ring 26 through the flange 24, which is separated from the cooled base plate 22 by the o-ring. Heat is also radiated from the process chamber 10 through the flange 24 to the o-ring 26. Consequently, with the approach in YAMAGA the o-ring 26 is still subject to thermal degradation and loss of vacuum or pressure in the process chamber 10. Also, the approach in YAMAGA does nothing to address thermal degradation of the o-ring 17 on the gas inlet 16, and the gasket 19 on the exhaust port 18.

Moreover, the use of water cooling introduces additional difficulties or problems, particularly for processes at temperatures above 100 °C (212°F). One problem is the potential for condensation of process gases initiated by the drastic reduction of temperature near the cooled base plate 22, which in turn can cause undesirable variations in the process or contamination of the substrates 14. This is particularly a concern with the latest generation of smaller single substrate processing chambers where a heated region or zone in which the substrate is processed may be separated from the seal by as few as several centimeters or inches.

Yet another problem with the use of water cooling is the potential for catastrophic damage to the process chamber 10 in the event of a failure in the cooling water supply. For instance, a loss of water now could result in the water in the cooled base plate 22 flashing to steam, warping or otherwise damaging the base.

Accordingly, there is a need for an apparatus and method for insulating and maintaining seals used in process chambers that are heated or in which heat is generated during processing. It is desirable that the apparatus and method be adaptable for use with seals used on apertures or openings into the process chamber, including for example gas inlets, exhaust ports and openings through which substrates or work pieces are loaded into the chamber.

The present invention preferably provides a solution to these and other problems, and may offer other advantages over the prior art.

It is a preferred object of the present invention to provide an apparatus and method for insulating and maintaining a seal in a pressurized, evacuated or exhausted process chamber.

According to one aspect of the present invention, a process chamber is provided for processing work pieces, such as semiconductor substrates, at high or elevated temperatures. The process chamber includes a wall having an aperture therein, a flange disposed about the aperture, and an insulator between the flange and a fixture to insulate a seal between the flange and the fixture. The insulator principally includes a tube or cooling loop having a sidewall overlying the flange and attached to the flange, and a cap overlying the cooling loop, the cap having a sealing surface against which the seal seats to seal the flange to the Fixture. In one embodiment fluid is passed through the cooling loop to reduce beat transferred to the seal from the process chamber during a processing operation. Generally, the flange, the cooling loop and the cap are made of a glass material or quartz. The sidewall of the cooling loop can be welded to the flange and the cap, or can be integrally formed therewith.

In one embodiment, the fixture is a door covering a doorway through which work pieces, such as semiconductor substrates, are loaded into the process chamber. Alternatively, the fixture can be a fitting or connection connecting the process chamber to a vacuum pump, an exhaust line, or a process or vent gas supply.

In another embodiment, the flange has a cylindrical shape open at a distal end distal from the process chamber, and the cooling loop has a curved substantially circular shape with a diameter substantially equal to that of the flange. The cooling loop itself can have an internal passage with either a circular or polygonal cross-sectional area, for example square. In one version of this embodiment, the cooling loop comprises a channel or groove machined into a portion of a surface of the flange, and the cap overlays the channel to form the internal passage through which the heat transfer fluid is passed to insulate the seal.

In yet another embodiment, the cooling loop is adapted to function as a light pipe to direct heat radiating from the process chamber away from the seal. Electromagnetic radiation or energy (light) is conducted through the material of the sidewall of the process chamber just as it does through an optical fiber in fiber optic communication. The presence of a discontinuity moving from one medium, such as quartz, to another medium such as a gas or fluid in the insulator results in reflection of some of the energy back towards a process zone, stabilizing and improving temperature control, and refraction away from the seal. The net effect is to greatly reduce the amount of electro-magnetic energy coupled to the vulnerable seal.

Preferably, the fluid passed through the cooling loop is a gas, to avoid stresses in the cooling loop, cap and flange resulting from drastic cooling near an inlet to the loop, differential cooling at different points along the cooling loop, or the impediment to heat transfer caused by vaporization of a liquid. More preferably, the gas is selected from the group consisting of air, nitrogen, helium or argon. In another version of this embodiment, the gas passed through the cooling loop or tube is a process gas used in the process chamber during the processing operation, and the gas is introduced into the process chamber after having passed through the cooling loop, thereby preheating the process gas prior to introduction into the process chamber. This embodiment is particularly desirable for those processes in which it is necessary to maintain a specified temperature profile in the process chamber while providing a high flow of process gases, for example in a Chemical Vapor Deposition (CVD) system.

According to another aspect of the present invention, a method is provided for insulating a seal between a process chamber and a fixture, the process chamber having a wall with an aperture therein, and a flange disposed about the aperture. Generally, the method involves: (i) attaching a cooling loop having a sidewall to the flange so that the sidewall overlies the flange; (ii) attaching a cap to the cooling loop, the cap having a sealing surface against which the seal seats to seal the flange to the fixture; and (iii) passing a fluid through the cooling loop to reduce heat transferred to the seal from the process chamber during a process operation. The step of attaching the cooling loop to the flange can be accomplished by welding the sidewall of the cooling loop to the flange.

In one embodiment, the flange includes a cylindrical shape open at a distal end distal from the process the chamber, and the step of attaching a cooling loop to the flange involves attaching a cooling loop curved substantially into a circle having a diameter substantially equal to the flange.

In another embodiment, the step of passing a fluid through the cooling loop includes the step of flowing a gas through the cooling loop. Preferably, the gas is selected from the group consisting of air, nitrogen, helium or argon. Alternatively, the gas is a process gas used in the process chamber during the processing operation, and the step of flowing a gas through the cooling loop involves introducing the process gas into the process chamber after flowing it through the cooling loop, thereby preheating the process gas prior to use.

In another aspect, an insulator is provided, as set out in claim 23.

These and various other features and advantages of the present invention will be apparent upon reading of the following detailed description in conjunction with the accompanying drawings and the appended claims provided below, where:
FIG. I (prior art) is a cross-sectional side view of a conventional process chamber for high temperature processing having a cooling loop on a fixture to which a flange on the process chamber is sealed by an o-ring seal;
FIG. 2 is a cross-sectional view of a process chamber having a flange to which an insulator is attached to insulate a seal sealing the flange to a fixture according to an embodiment of the present invention;
FIG. 3A is a partial cross-sectional view of the insulator, the flange, and the fixture of the process chamber of FIG. 2 according to an embodiment of the present invention;
FIG. 3B is a planar top view of the flange and the insulator of FIG. 2 according to an embodiment of the present invention;
FIG. 4 is a partial cross-sectional view of an exhaust port in a process chamber having a flange to which an insulator is attached according to an embodiment of the present invention;
FIG. 5 is a partial cross-sectional view of an alternative embodiment of a cooling loop of an insulator according to the present invention;
FIG. 6 is a partial cross-sectional view of a flange having a cooling loop of an insulator integrally formed therein according to an alternative embodiment of the present invention;
FIG. 7 is a partial cross-sectional view of the flange and the insulator having multiple stacked cooling tubes according to an embodiment of the present invention;
FIG. 8 is a planar top view of the flange and the insulator having multiple concentric cooling tubes according to an embodiment of the present invention;
FIG. 9 is a planar top view of the flange and the insulator having a cooling tube divided into segments each of which cool and insulate a portion of the total circumference or diameter of the seal according to an embodiment of the present invention;
FIG. 10 is a flow chart showing steps of a method for insulating a seal between a process chamber and a fixture according to an embodiment of the present invention, and
FIG. 11 is a graph showing temperature as a function of time to illustrate insulating of a seal by an insulator according to an embodiment of the present invention with and without fluid flow through the cooling loop.

The present invention is directed to an apparatus and method for insulating and maintaining a seal in pressurized, evacuated or exhausted process chambers. Although, described with reference to specific embodiments and examples of heated process chambers, these have been presented for the purpose of illustration and description only, and it will be appreciated that the inventive apparatus and method are also applicable to process chambers in which heat is generated during processing.

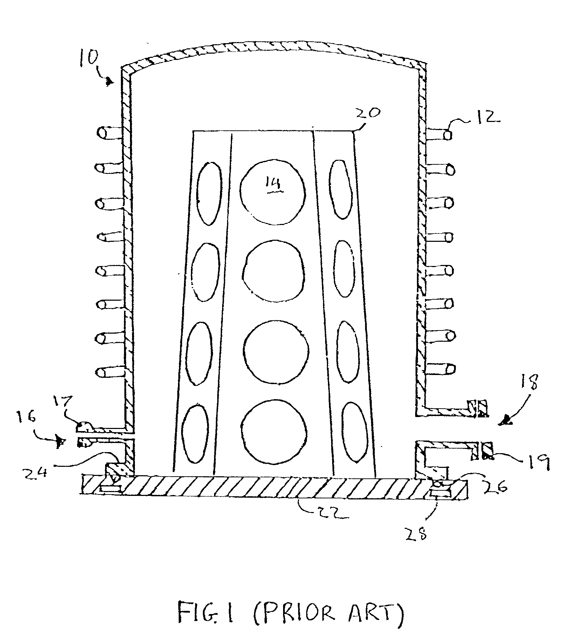

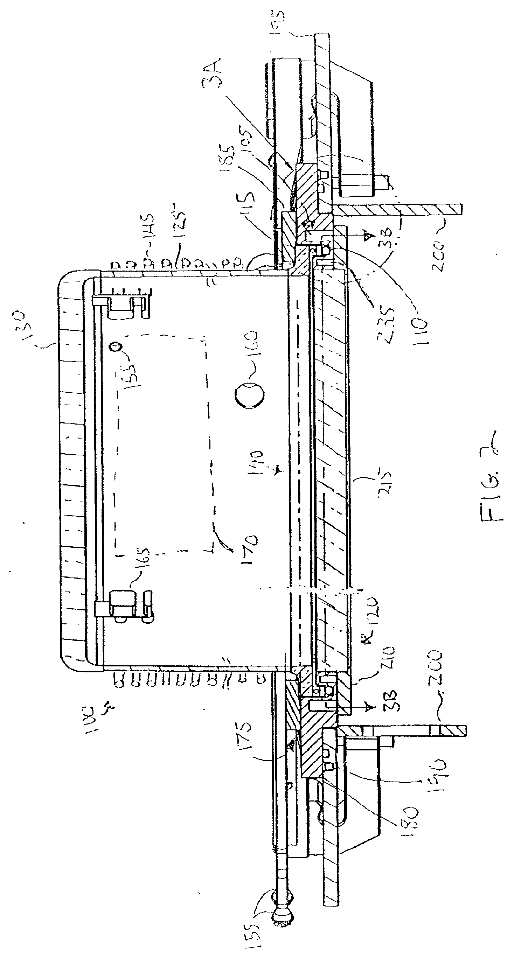

An embodiment of a process chamber 100 having an insulator 105 for insulating and maintaining a seal 110 according to an embodiment of the present invention will now be described with reference to FIG. 2. FIG. 2 is a cross-sectional view of a heated process chamber 100 having a flange 115 to which the insulator 105 is attached to insulate the seal 110. The seal 110 generally seals the flange to a fixture, such as a door 120 shown in the exemplary embodiment For purposes of clarity, many details of heated process chamber 100 or furnaces that are widely known and are not relevant to the present invention have been omitted.

Referring to FIG. 2, the process chamber 100 generally includes a wall or sidewall 125, an end wall 130, and the flange 115 disposed about or defining an aperture or opening 140, such as à doorway at one end of the sidewall through which work pieces, such as semiconductor substrates or wafers (not shown) can be loaded into the process chamber. Furnace or coaxial heating elements 145 surround or are disposed about the process chamber 100 to thermally treat or heat the work piece therein to an elevated temperature. In one embodiment the work pieces is heated to at 1100 °C (2012°F) and more preferably from about 1200 °C (2192°F) to about 1500 °C (2732°F) Generally, the process chamber 100 can consist of any material capable of withstanding the heat, pressure of an evacuated or pressurized process chamber, and chemicals used in processing the work pieces. Suitable materials for the process chamber 100 include, high temperature glass, ceramics, and clear or opaque quartz glass or quartz. In a preferred embodiment, the process chamber 100 is a long quartz cylinder closed at one end by the end wall 130 and at the outer end by a fixture such as a door 120, also made of quartz. This embodiment is particularly suitable for use with fumaces, such as Rapid Vertical Processors, Vertical Thermal Reactors, and Horizontal Thermal Reactors commercially available from ASML Inc., of La Veldhoven, The Netherlands, which are widely used in semiconductor manufacturing to, for example, anneal, diffuse or drive in dopant material, and to grow or deposit oxide or poly silicon layers on substrates.

Generally, the process chamber 100 includes one or more gas inlets 155 for introducing process and/or vent gases therein, and an exhaust port 160 for exhausting spent process gases and/or byproducts. Optionally, the exhaust port 160 can be coupled to a vacuum pump (not shown) to evacuate the process chamber 100 for processes performed at a high or low vacuum. The process chamber 100 can further include one or more holders 165 for holding and positioning one or more substrates (not shown) within a process zone 170 in the process chamber. The process zone 170 is a region within the process chamber 100 in which temperature and the concentration of process gases is tightly controlled to facilitate the processing of the substrates.

The process chamber 100 is supported within the furnace or the heating elements 145 by a clamp 175 including a front or face-piece 180 disposed about an outer circumference of the flange 115, and a backing ring or piece 185 having an internal diameter smaller than an outer diameter of the flange but larger than that of the sidewall 125 of the process chamber 100. Generally, the clamp 175 is attached by mechanical fasteners 190 to a front plate 195 or wall of the furnace or an enclosure containing the heating the elements 145. Optionally, brackets 200 may be attached to the front plate 195 or the clamp 175 for mounting a mechanism (not shown) for automatically loading substrates and/or opening and closing the door 120.

In one embodiment, the door 120 includes a metal ring 210 disposed about and sealed by a gas tight seal to a central quartz plate or disc 215 that substantially covers the opening 140 into the process chamber 100. The surface of the metal ring 210 is treated or coated with a matezial to resist corrosion or reaction with the process gases or byproducts. Alternatively, the door 120 can be made entirely of quartz or metal. The metal ring 210 includes a groove 220 for holding a polymeric seal 110, such as an o-ring or a seal having a square cross-sectional area, for sealing with the flange 115 to provide a substantially gas tight seal. Optionally, the door 120 further includes a cooling channel 235 through which a heat transfer fluid, such as water, is circulated to cool the seal 110.

The material of the seal 110 is selected for its resilience and ability to provide a satisfactory seal, and for it ability to withstand the process gases or byproducts and the heat from the process chamber 100. Suitable materials include, for example, resilient polymeric material such as silicone, fluorosilicone, tetrafluoroethylene/Propylene or TFE/Propylene, fluorocarbon, polyacrylate, nitrite, hydrogenated nitrile, neoprene, ethylene propylene or butyl rubber. In accordance with the present invention, the seal 110 seals with an insulator 105 attached to the flange 115 to insulate and maintain a seal in a pressurized, evacuated or exhausted process chambers 100.

By maintaining the seal 110 within designed operating temperatures, the insulator 105 and the method described provide, inter alia, improved seal 110 integrity, and improved process stability and personnel safety due to improved seal integrity. In addition, the insulator 105 and method reduce potential for process chamber 100 contamination due to thermally degraded seal 110, and reduced operating costs and increased equipment availability due to extended seal lifetime.

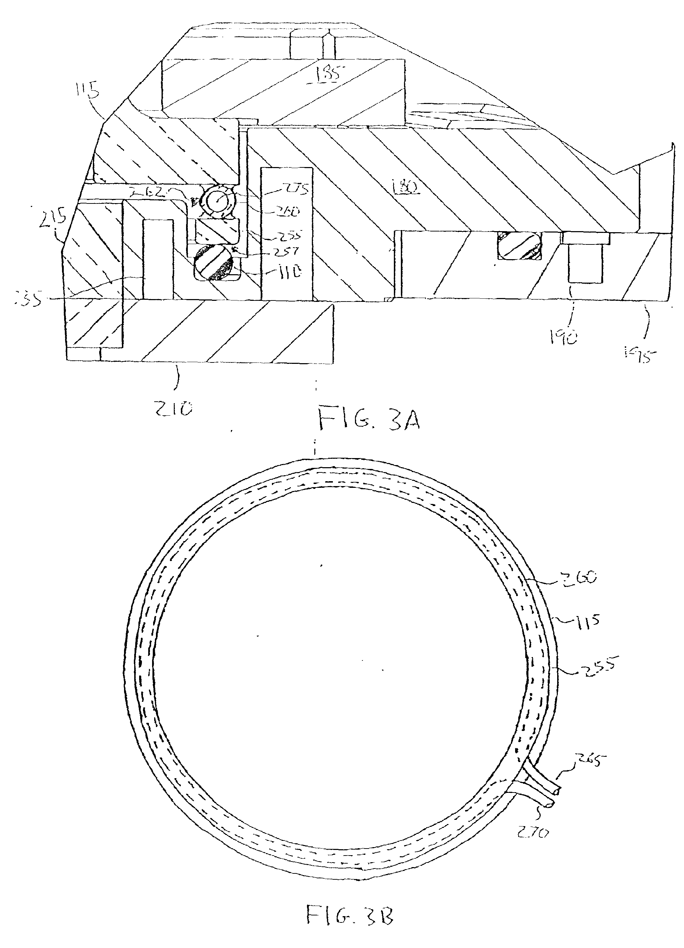

The insulator 105 shown in FIG. 2 will now be described in more detail with reference to FIGs. 3A and 3B FIG. 3A is a partial cross-sectional view of an insulator 105, flange 115 and a door 120 through which work pieces, such as semiconductor substrates, can be loaded into the process chamber 100. FIG. 3B is a planar top view of the flange 115 and the insulator 105 of FIG. 2. Referring to FIG. 3A, the insulator 105 generally includes an annular cap 255 having a sealing surface 257 against which the seal 110 is pressed when the door 120 is in the closed position, and a cooling loop or tube 260 between the cap and the flange. The cooling tube 260 includes an inlet 265 (shown in FIG 3B), an outlet 270 (shown in FIG. 3B), and walls or sidewall 262 defining an internal passage 275 through which a heat transfer fluid is passed or flowed. The heat transfer fluid cools the seal 110 and/or insulates it from heat transferred from the process chamber 100 to reduce or substantially eliminate thermal degradation of the seal. Preferably, the cooling tube 260 and cap 255 are made of glass or quartz and the cooling loop is fused or welded to the flange 115 and to the cap with quartz to form a substantially gas tight structure. In addition to the cooling and insulating effect of the heat transfer fluid, the reduced surface area of the cooling tube 260 in contact with the flange 115 and the cap 255 serves a thermal barrier to reduce conduction of heat from the process chamber 100 to the teal 110.

Optionally, the flange 115, the cooling tube 260, the cap 255 and/or a portion of the sidewall 125 of the process chamber 100 can be made from opaque quartz to further reduce the transfer of heat from the process chamber 100 to the seal 110. Opaque quartz is quartz in which microscopic air bubbles have been introduced during the manufacturing process before the quartz has solidified. These microscopic air bubbles reduce the rate at which heat is conducted through the opaque quartz and the rate at which heat is radiated from the process chamber 100 to the seal 110. In an effect known as light piping, electro-magnetic radiation or energy (light) can travel through the material of the sidewall 125 of the process chamber 100 just as it does through an optical fiber in fiber optic communication. The presence of a discontinuity moving from one medium, such as quartz, to another medium such as the microscopic air bubbles in the opaque quartz results in refraction and reflection of some of the energy. That is, some of the energy is reflected back to the process zone 170, and away from the seal 110.

These microscopic air bubbles reduce both the rate at which heat is conducted through the opaque quartz and the rate at which heat is radiated or light-piped from the process chamber 100 to the seal 110.

The heat transfer fluid can include a gas, such as air, nitrogen, helium or argon, or a liquid such water. To prevent damage to the insulator 105, the flange 115 and the process chamber 100 that could result from stresses caused by a failure in supply of the liquid heat transfer fluid, it is desirable that the use of liquid be limited to processes performed at temperatures below the vaporization temperature of the liquid. In particular, owing to the potential for condensation and for damage to the insulator 105 and the process chamber 100 described above, the use of water should be limited to processes performed at temperatures below 100 °C (212°F).

Preferably, the heat transfer fluid is a gas. More preferably, the rate at which the gas flows through the cooling loop 260 is selected based on the operating temperature of the process chamber 100, the size of the cooling loop and the size of the seal 110, to maintain the seal at or below its maximum rated temperature for a predetermined process time. For example, to maintain a silicone seal which has a diameter of about 41 cm (16 inches) at a temperature below about 350 °C (662°F), employed on a process chamber operating at about 1100 °C (2012°F), it is desirable to provide a cooling loop 260 having a diameter or circumference of about 41 cm (16 inches) made from tubing having an inner diameter of at least 2.5 mm (0.0975 inches) and having a gas flow through the cooling loop 260 of from about 2 to about 200 liters per minute (LPM), and more preferably of from about 20 LPM at from about 30 pounds per square inch (PSI) to 60 PSI.

In one embodiment, the gas flowed through the cooling loop 260 is a process or vent gas that is flowed through the cooling loop before being introduced into the process chamber 100. This embodiment has the advantage of cooling and insulating the seal 110 while simultaneously preheating the gas thereby helping the heating elements 145 to maintain a stable, elevated temperature in the process zone 170.

In another embodiment, the cooling loop 260 is sized, shaped and made from a material selected to enable the cooling loop to function as a light pipe to direct heat radiating from the piocess chamber 100 away from the seal 110. As explained above, electro-magnetic radiation or energy (light) can travel through the material of the sidewall 125 of the process chamber 100 just as it does through an optical fiber in fiber optic communication. The presence of a discontinuity moving from one medium, such as quartz, to another medium such as a gas or fluid in the cooling loop 260 results in refraction and reflection of some of the energy. That is, some of the energy is reflected back to the process zone 170, and some is refracted away from its original direction of travel and away from the seal 110. The net effect is to greatly reduce the amount of electro-magnetic energy coupled to the vulnerable seal 110.

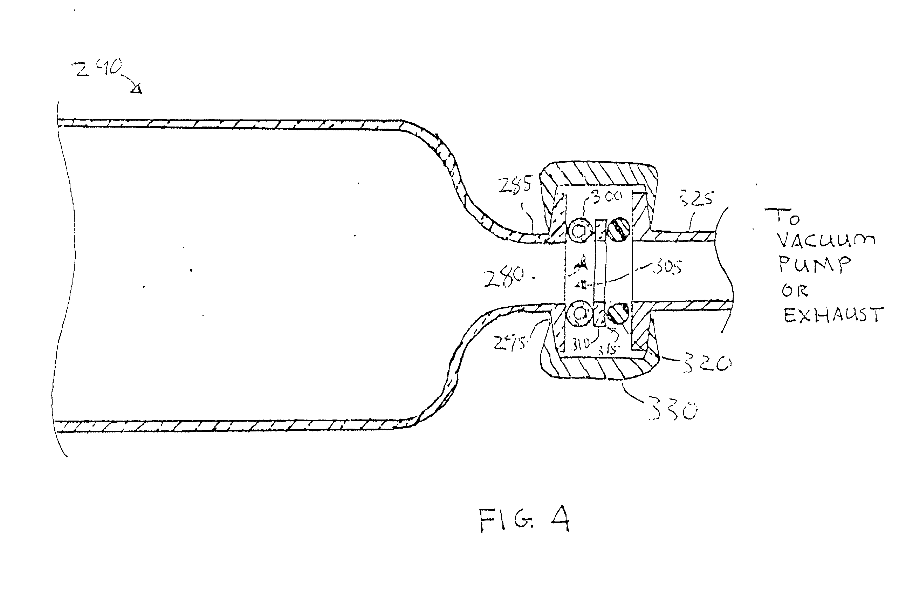

An embodiment of an insulator 280 suitable for sealing an exhaust or evacuation line to an exhaust port 285 of a process chamber 290 will now be described with reference to FIG. 4. FIG. 4 is a partial cross-sectional view of an exhaust port 285 in a process chamber 290 having a flange 295 to which an insulator 280 according to an embodiment of the present invention is attached. Referring to FIG. 4, the insulator 280 generally includes a quartz cooling tube or loop 300 welded to and between the flange 295 disposed about or defining an opening 305 in the process chamber 290, and an annular cap 310 having a sealing surface 315 against which a seal 320 is pressed when the flange 295 is coupled to a fixture 325 such as a foreline of a vacnum pump or an exhaust trunk (not shown). The flange 295 is coupled to the fixture 325 by, for example, a clamp 330. Optionally, the fixture 325 can include a cooling channel (not shown) near the seal 320, and through which water is passed to cool the seal further.

A smaller version of an insulator according to an embodiment of the present invention, similar to that described above, can be used to insulate a seal in a gas inlet to a process chamber (not shown). It will be appreciated that this embodiment is particularly suited for using a process gas or vent gas as the heat transfer fluid.

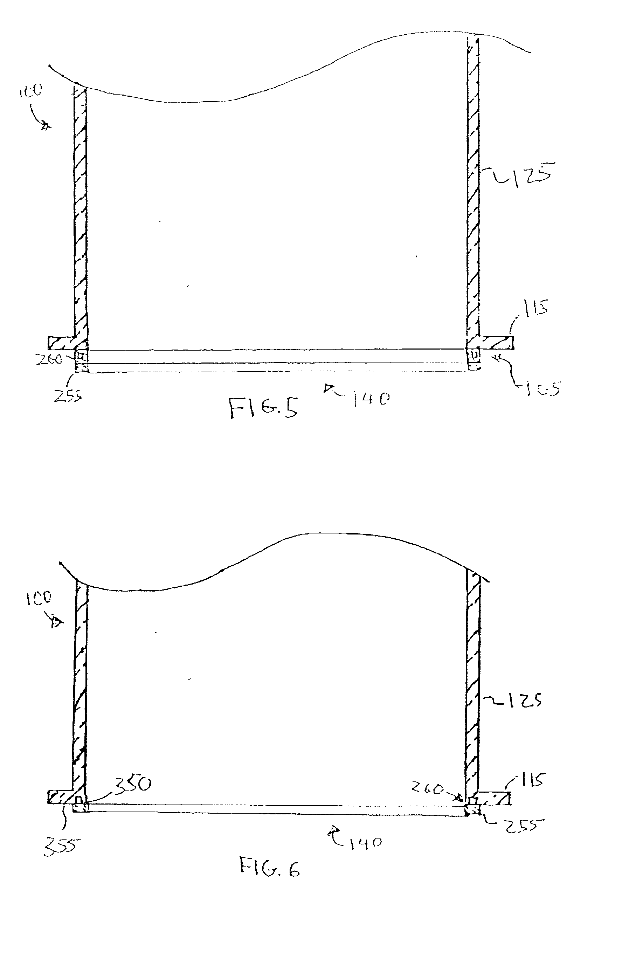

Alternative embodiments of the insulator 105 will now be described with reference to FIGs 5 to 8.

In an embodiment, shown in FIG. 5, the cooling tube 260 of the insulator 105 has a square cross-sectional area This embodiment has the advantages of providing a larger area of a sidewall 335 of the cooling tube in contact with the flange 115, thereby increasing the strength of the welded joint 340 between the insulator 105 and the flange 115. In addition, the cap 255 or sealing surface 257 can be integrally formed with the cooling loop 260 by providing a substantially flat planar surface on an outside surface of the cooling loop facing away from the flange 115, arid against which the seal 110 will seat. Thus, this embodiment has the further advantage of reducing manufacturing time and costs by eliminating a part, the cap 255, and one or more steps, i.e., the steps of manufacturing the cap and attaching it to the cooling loop 260.

In another embodiment, shown in FIG. 6, the cooling tube 260 of the insulator 105 is integrally formed in the flange 115. In this embodiment, the cooling tube 260 comprises a channel 350 or groove machined into part of a surface 355 of the flange 115, and the cap 255 overlaying the channel to form the internal passage 275 through which the heat transfer fluid is passed. This embodiment has the advantage of eliminating the weld between the cooling loop 260 and the flange 115 thereby eliminating a potential source of leaks.

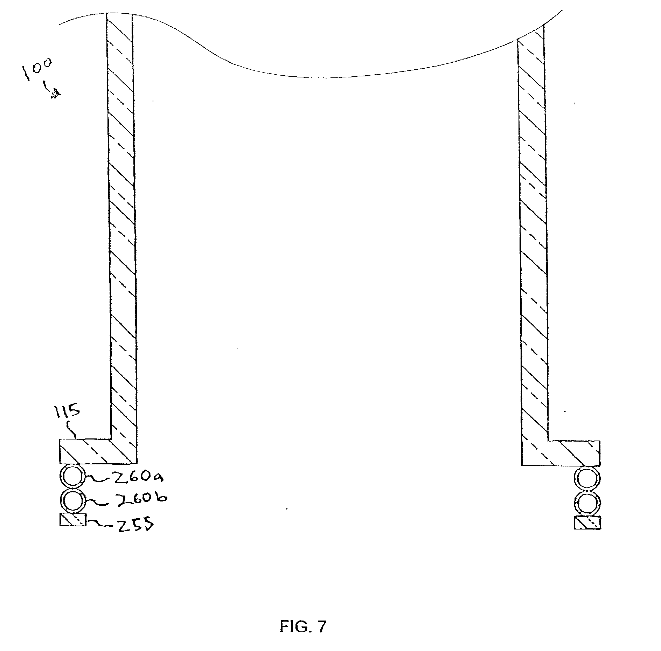

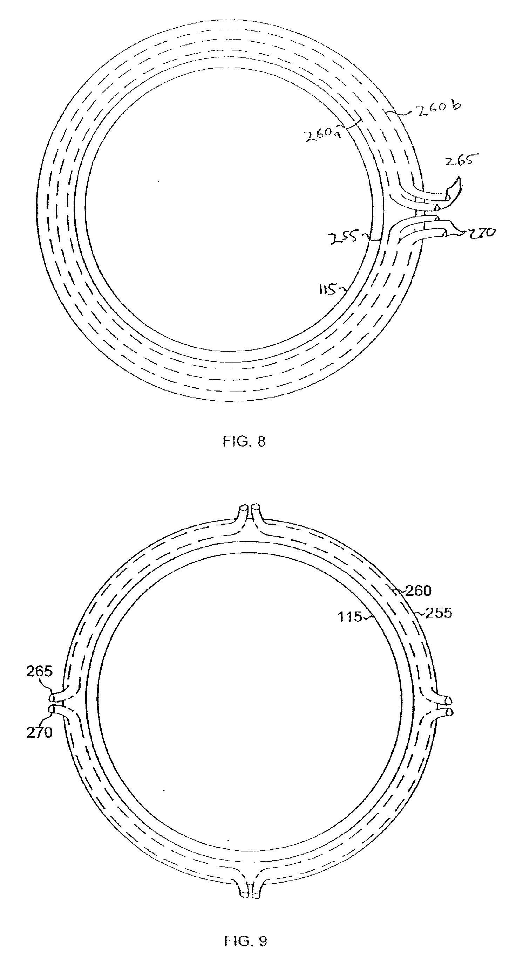

In other alternative embodiments, shown in FIGs. 7 and 8, the insulator 105 can include multiple cooling tubes 260 to further cool and insulate the seal 110. In FIG. 7, the insulator 105 includes multiple stacked cooling tubes 260a, 260b, between the flange 115 and the cap 255. FIG. 8 illustrates an insulator 105 having multiple concentric cooling tubes 260a, 260b, between the flange 115 and the cap 255

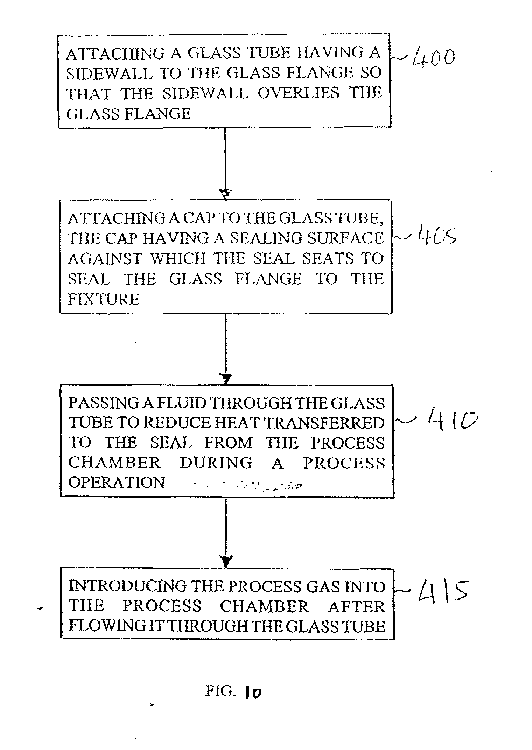

In yet another alternative embodiment, the insulator 105 can include segmented cooling tubes 260, wherein each segment cools and insulates a portion of the seal. In the embodiment shown in FIG. 9 the cooling tube 260 is divided into four segments each of which cool and insulate a quarter of the total circumference or diameter of the seal 110.

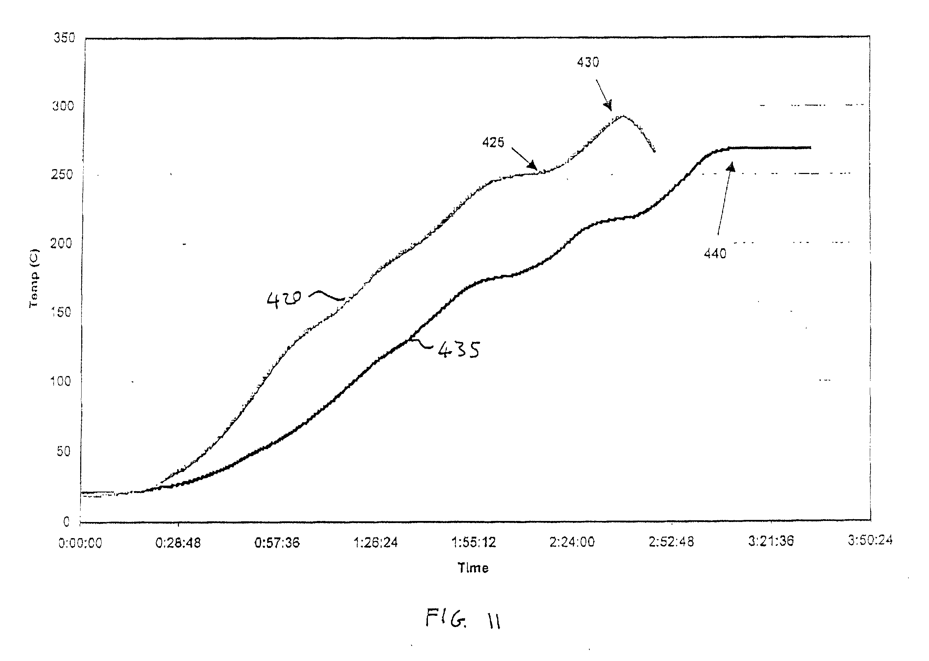

An embodiment of a method for insulating and maintaining a seal 110 between a process chamber 100 and a fixture (such as door 120) according to an embodiment of the present invention will now be described with reference to FIG. 10. FIG. 10 is a flow chart showing steps of a method for insulating a seal 110 between a process chamber 100 and a fixture. Generally, the method involves: (i) attaching a cooling tube or loop 260 having a sidewall 262 to the flange 115 so that the sidewall overlies the flange (step 400); (ii) attaching a cap 255 to the cooling loop 260, the cap having a sealing surface 257 against which the seal 110 seats to seal the flange 115 to the fixture (step 405); and (iii) passing a fluid through the cooling loop 260 to reduce heat transferred to the seal 110 from the process chamber 100 during a process operation (step 410). The step of attaching the cooling loop 260 to the flange 115 can be accomplished by welding the sidewall 262 of the cooling loop to the flange.

In one embodiment, the flange 115 includes a cylindrical shape open at a distal end distal from the process chamber 100, and the step of attaching a cooling loop 260 to the flange, step 400, involves attaching a cooling loop curved substantially into a circle having a diameter substantially equal to that of the flange.

In another embodiment, the step of passing a fluid through the cooling loop 260, step 410, includes the step of flowing a gas through the cooling loop. Preferably, the gas is selected from the group consisting of air, nitrogen, helium or argon. Alternatively, the gas is a process gas used in the process chamber 100 during the processing operation, and the method further includes the step of introducing the process gas into the process chamber (step 415) after flowing it through the cooling loop 260, step 410, thereby preheating the process gas prior to use.

### EXAMPLES

The following examples illustrate advantages of an apparatus and method embodying the present invention for insulating a seal 110 in heated process chamber 100. The examples are provided to illustrate certain embodiments of the present invention, and are not intended to limit the scope of the invention in any way.

Referring to FIG. 11. the first example, illustrated by graph 420, demonstrates the ability of an insulator 105 according to an embodiment of the present invention to insulate a seal 110 solely by light piping and the thermal barrier effect without fluid flow through the cooling tube 260. In this example, the inlet 265 and outlet 270 to the cooling tube 260 were left open to atmosphere, and water was passed through the cooling channel 235 in the door 120 at a rate of two and half gallons per minute (GPM). Thermocouples or TCs were positioned radially spaced apart about the o-ring seal 110. After about two and a half hours of heating, the process chamber 100 reached a temperature of 500 °C in the process zone 170 resulting in a maximum o-ring temperature of about 250 °C, as shown in FIG 11 by reference number 425, well below the rated maximum temperature of most types of o-rings used in this application.

At this time, the heater set point was increased to 900 °C resulting in a maximum o-ring temperature of about 285C after about half an hour of heating, as indicated by reference number 430.

A second example, illustrated by graph 435, demonstrates the ability of an insulator 105 according to an embodiment of the present invention to insulate a seal 110 when a fluid is flowing through the cooling loop 260. In this example, nitrogen (N₂) at a rate of 160 cubic feet per hour (Cfh) was passed through the cooling loop 260, and water was passed through the cooling channel 235 in the door at a rate of two and half gallons per minute (GPM). After about three hours of heating the temperature in the process zone 170 reached a steady value about 1100 C, while the seal 110 reached a maximum of about 270 C, as shown by reference number 440.

The foregoing description of specific embodiments and examples of the invention have been presented for the purpose of illustration and description, and although the invention has been illustrated by certain of the preceding examples, it is not to be construed as being limited thereby. They are not intended to be exhaustive or to limit the invention to the precise forms disclosed, and obviously many modifications, embodiments, and variations are possible in light of the above teaching. It is intended that the scope of the invention encompass the generic area as herein disclosed.

## Claims

1. A process chamber comprising;
a wall having an aperture therein;
a flange disposed about the aperture; and
an insulator between the flange and a fixture to insulate a seal between the flange and the fixture, the insulator comprising:
a cooling tube having a sidewall overlying the flange and attached to the flange; and
a cap overlying the cooling tube, the cap having a sealing surface against which the seal seats to seal the flange to the fixture,
wherein the cooling tube reduces heat transferred to the seal from the process chamber during a processing operation.

2. A process chamber according to claim 1, wherein the flange, the cooling tube and the cap are comprised of quartz.

3. A process chamber according to claim 2. wherein the flange comprises opaque quartz to reduce heat radiating from the process chamber toward the seal.

4. A process chamber according to claim 2, wherein the flange comprises a cylindrical shape open at a distal end distal from the process chamber, and wherein the cooling tube comprises a curved substantially circular shape having a diameter substantially equal to the flange.

5. A process chamber according to claim 2, wherein the cooling tube is adapted to function as light pipe to direct heat radiating from the process chamber away from the seal.

6. A process chamber according to claim 1, wherein a fluid is passed through the cooling tube.

7. A process chamber according to claim 6, wherein the fluid is a gas and is selected from the group consisting of:
air;
nitrogen;
helium; and
argon.

8. A process chamber according to claim 6, wherein the fluid is a process gas used in the process chamber during the processing operation, and wherein the process gas is introduced into the process chamber after having passed through the cooling tube,
such that the process gas is preheated prior to introduction into the process chamber.

9. A process chamber according to claim 1, wherein the sidewall of the cooling tube is welded to the flange

10. A process chamber according to claim 1, wherein the cooling tube is integrally formed with the flange.

11. A process chamber according to claim 1, wherein the aperture comprises a doorway through which a semiconductor substrate is loaded into the process chamber.

12. A process chamber according to claim 1, wherein the process chamber is pressurized, evacuated or exhausted.

13. A process chamber according to claim 1, wherein the insulator further includes an additional cooling tube having a sidewall overlying the flange and attached thereto and concentric with the cooling tube.

14. A process chamber according to claim I, wherein the cooling tube is a segmented cooling tube, in which each segment reduces heat transferred to a portion of the seal.

15. A process chamber according to claim 1, wheiem the insulator further includes an additional cooling tube having a sidewall overlying and concentric with the cooling tube, and attached to the cooling tube and to the cap

16. A method of insulating a seal between a glass process chamber and a fixture, the process chamber having a wall with an aperture therein, and a glass flange disposed about the aperture, the method comprising steps of.
attaching a cooling tube having a sidewall to the flange so that the sidewall overlies the flange;
attaching a cap to the cooling tube, the cap having a sealing surface against which the seal seats to seal the flange to the fixture; and
passing a fluid through the cooling tube to reduce heat transferred to the seal from the glass process chamber during a process operation.

17. A method according to claim 16, wherein the flange comprises a cylindrical shape open at a distal end distal from the process the chamber, and wherein the step of attaching a cooling tube comprises the step of attaching a cooling tube curved substantially into a circle having a diameter substantially equal to the glass flange.

18. A method according to claim 16, wherein the step of attaching a cooling tube comprises the step of attaching a cooling tube adapted to function as a light pipe to direct heat radiating from the glass process chamber away from the seal.

19. A method according to claim 16, wherein the step of passing a fluid through the cooling tube comprises the step of flowing a gas through the cooling tube.

20. A method according to claim 19, wherein the step of passing a gas through the cooling tube comprises the step of flowing a gas selected from the group consisting of:
air;
nitrogen;
helium; and
argon.

21. A method according to claim 19, wherein the gas is a process gas used in the glass process chamber during the processing operation, and wherein the step of flowing a gas through the cooling tube comprises the step of introducing the into the glass process chamber after flowing it through the cooling tube,
such that the process gas is preheated prior to introduction into the glass process chamber.

22. A method according to claim 16, wherein the cooling tube comprises glass, and wherein the step of attaching a cooling tube to the glass flange comprises the step of welding the sidewall of the cooling tube to the flange.

23. An insulator for insulating a seal between a process chamber and a fixture, the process chamber having a wall with an aperture therein, and a glass flange disposed about the aperture, the insulator comprising:
a glass cap having a sealing surface against which the seal seats to seal the glass flange to the fixture, and
heat transfer means for transporting a heat transfer fluid between the glass flange and the glass cap,
wherein the heat transfer fluid passed through the heat transfer means reduces heat transferred to the seal from the process chamber during a process operation.

24. An insulator according to claim 23, wherein the heat transfer means comprises a channel machined into a portion of a surface of the glass flange, and wherein the glass cap is welded over the channel to form a cooling tube through which the heat transfer fluid is passed.

25. An insulator according to claim 23, wherein the heat transfer means comprises a cooling tube having an outer wall, one side of which is welded to the glass flange, and wherein the glass cap is welded to a portion of the outer wall facing away from the glass flange.
